Europäisches Patentamt

European Patent Office

Office européen des brevets

(11) Veröffentlichungsnummer: **0 504 988 A2**

# EUROPÄISCHE PATENTANMELDUNG

(21) Anmeldenummer: **92200711.7**

(22) Anmeldetag: **12.03.92**

(51) Int. Cl.5: **H03G 5/16**, H03G 9/02

(30) Priorität: **21.03.91 DE 4109211**

(43) Veröffentlichungstag der Anmeldung:
**23.09.92 Patentblatt 92/39**

(84) Benannte Vertragsstaaten:
**AT BE DE FR GB IT NL**

(71) Anmelder: **Philips Patentverwaltung GmbH**
**Wendenstrasse 35 Postfach 10 51 49**
**W-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **BE FR GB IT NL AT**

(72) Erfinder: **Sauvagerd, Ulrich, Dr.**
**Frohmestrasse 72a**
**W-2000 Hamburg 61(DE)**
Erfinder: **Strassenburg, Bernd**
**Barenbleek 1**
**W-2000 Hamburg 71(DE)**

(74) Vertreter: **von Laue, Hanns-Ulrich, Dipl.-Ing. et**
**al**
**Philips Patentverwaltung GmbH,**
**Wendenstrasse 35, Postfach 10 51 49**
**W-2000 Hamburg 1(DE)**

(54) **Schaltungsanordnung zur Frequenzgangbeeinflussung eines digitalen Audiosignals.**

(57) Für eine digitale Schaltungsanordnung zur frequenz- und/oder amplitudenabhängigen Frequenzgangbeeinflussung eines digitalen Audiosignals ist vorgesehen, daß das Eingangssignal der Schaltungsanordnung einem Signalfilter (3) mit variablen Filterkoeffizienten zugeführt wird, dessen Ausgangssignal nach Addition mit dem Eingangssignal der Schaltungsanordnung das frequenzgangbeeinflußte Ausgangssignal der Schaltungsanordnung darstellt, und daß die Koeffizientenauswahl für das Signalfilter in Abhängigkeit des Ausgangssignals eines Steuerungszweiges vorgenommen wird, welchem das Eingangssignal der Schaltungsanordnung zugeführt wird und welcher ein Steuerungsfilter (7), einen Gleichrichter (8), eine Impulsformerstufe (9), einen Logarithmierer (12) und eine Koeffizientenermittlungsanordnung (6) aufweist.

FIG.1

Die Erfindung betrifft eine digitale Schaltungsanordnung zur frequenz- und/oder amplitudenabhängigen Frequenzgangbeeinflussung eines digitalen Audiosignals.

Derartige Schaltungsanorndungen werden insbesondere in Rauschunterdrückungssystemen benötigt, welche das nach Aufzeichnung und anschließendem Wiedergeben von einem Tonträger entstehende Rauschen unterdrücken sollen. Derartige bekannte Systeme sind z.B. das dbx, das HIGHCOM-System sowie die verschiedenen Dolby-Systeme. Bei letzteren Rauschunterdrückungssystemen wird in Abhängigkeit der Frequenz und der Amplitude eines Signals eine vorgegebene Filtercharakteristik bezüglich ihres Einsatzpunktes und bezüglich des Ausmaßes ihrer Auswirkung auf das Audiosignal eingestellt. Derartige Systeme werden meist als "Sliding-Band Systeme" bezeichnet.

Für diese Rauschunterdrückungssysteme ist ein Enkoder vorgesehen, welcher beispielsweise in Abhängigkeit der Frequenz und/oder der Amplitude eines Signals den oberen Frequenzbereich des Audiosignals aufnahmeseitig anhebt, sowie ein Dekoder, welcher in spiegelbildlicher Weise den gleichen Frequenzbereich wiedergabeseitig wieder absenkt.

Für die meisten Rauschunterdrückungssysteme der oben beschriebenen Art gilt, daß für sie ausschließlich analog arbeitende Schaltungsanordnungen bekannt sind. Dies hat seine Ursache darin, daß diese Schaltungsanordnungen im allgemeinen nur für analoge Audiosignale eingesetzt werden. In letzter Zeit sind jedoch zunehmend digital arbeitende Geräte zur Wiedergabe von Audiosignalen am Markt, welche u.a. auch dafür geeignet sein sollen, analoge Audiosignale wiederzugeben. In diesem Zusammenhang ist es dann auch wünschenswert, eine digital arbeitende Schaltungsanordnung vorzusehen, welche gemäß einem Rauschunterdrückungssystem eine frequenz- und/oder amplitudenabhängige Frequenzgangbeeinflussung des digitalen Audiosignals vornehmen kann.

Diese Aufgabe ist erfindungsgemäß dadurch gelöst, daß das Eingangssignal der Schaltungsanordnung einem Signalfilter mit variablen Filterkoeffizienten zugeführt wird, dessen Ausgangssignal nach Addition mit dem Eingangssignal der Schaltungsanordnung das frequenzgangbeeinflußte Ausgangssignal der Schaltungsanordnung darstellt, und daß die Koeffizientenauswahl für das Signalfilter in Abhängigkeit des Ausgangssignals eines Steuerungszweiges vorgenommen wird, welchem das Eingangssignal der Schaltungsanordnung zugeführt wird und welcher ein Steuerungsfilter, einen Gleichrichter, eine Impulsformerstufe, einen Logarithmierer und eine Koeffizientenermittlungsanordnung aufweist, welche die Filterkoeffizienten für das Signalfilter liefert.

Die erfindungsgemäße Schaltungsanordnung arbeitet im Gegensatz zu den bekannten analogen Anordnungen nicht rekursiv, da dieses in digitalen Systemen Probleme aufwirft. Gleichwohl muß die Schaltungsanordnung in der Lage sein, nicht nur bezüglich des Amplituden-Verhaltens sondern auch bezüglich des Impuls-Verhaltens die Eigenschaften analoger Systeme nachzubilden. Ein grundsätzliches Problem besteht in diesem Zusammenhang darin, daß für die meisten Rauschunterdrückungssysteme nicht die gewünschten frequenz- und/oder amplitudenabhängigen Frequenzgangkurven als Normung angegeben werden, sondern daß bestimmte analoge Schaltungsanordnungen in ihren Grundzügen vorgeschrieben sind. Das Verhalten dieser Schaltungsanordnungen ist nicht festgelegt, sondern ergibt sich sozusagen automatisch aus ihrem Aufbau heraus. Soll nun das Verhalten dieser analogen Schaltungsanordnungen im digitalen Bereich quasi nachgeahmt werden, so muß eine entsprechende digitale Schaltungsanorndung sehr flexibel ausgelegt sein, d.h. es muß möglich sein, ein nahezu beliebiges Amplituden- und/oder Impulsverhalten zu erhalten. Soll eine bestimmte Charakteristik eines bestimmten Rauschunterdrückungssystems nachgeahmt werden, so können die entsprechenden Frequenzgangkurven und das dynamische Verhalten der Schaltung nur auf experimentiellen Wege ermittelt werden.

In den erfindungsgemäßen digitalen Schaltungsanordnungen sind diese Anforderungen dadurch erfüllt, daß ein Signalfilter vorgesehen ist, welches mit variablen Filterkoeffizienten arbeitet. Diese Filterkoeffizienten können je nach Frequenz und/oder Amplitude des Eingangssignals der Schaltungsanordnung wunschgemäß eingestellt werden. Dies gilt sowohl für den statischen Fall, d.h. also, daß ein Eingangssignal konstanter Frequenz und Amplitude anliegt, wie auch für den dynamischen Fall, wenn sich also das Eingangssignal bezüglich Frequenz und/oder Amplitude ändert.

Die Koeffizientenauswahl für das Signalfilter geschieht in einem Steuerungszweig, dem das Eingangssignal der Schaltungsanordnung zugeführt wird. In diesem Steuerungszweig ist ein Steuerungsfilter vorgesehen, dem ein Gleichrichter nachgeschaltet ist. Das Ausgangssignal des Gleichrichters gelangt auf eine Impulsformerstufe, der ihrerseits ein Logarithmierer folgt. In Abhängigkeit des Ausgangssignals des Logarithmierers werden die Koeffizienten in einer Koeffizientenermittlungsanordnung eingestellt.

Die Auslegung der einzelnen Komponenten der Schaltungsanordnung ist je nach gewünschter Frequenzgangbeeinflussung und je nach gewünschtem dynamischen Verhalten verschieden.

So ist das Signalfilter bezüglich seiner Filtercharakteristik an die gewünschten in Abhängigkeit der Frequenz und/oder Amplitude des Eingangssignals einzustellenden Frequenzverläufe anzupassen. Das Steuerungsfilter im Steuerungszweig bestimmt sowohl das statische wie auch das dynamische Verhalten der Schaltungsanordnung. Die Filterkurve dieses Filters ist so auszulegen, daß die Filterkoeffizienten für das Signalfilter in gewünschter Weise variiert werden können. Der Impulsformer bestimmt das dynamische Verhalten. Dies geschieht dadurch, daß die von dem Steuerungsfilter kommenden Signale in dem Impulsformer bezüglich ihrer Anstiegs- und/oder Abfallzeitkonstanten beeinflußt werden können. Die Wahl dieser Zeitkonstanten wiederum bestimmt, mit welchen minimalen Zeitkonstanten die Filterkoeffizienten nach einem Amplituden- und/oder Frequenzsprung des Eingangssignals der Schaltungsanordnung auf die neue Amplitude bzw. Frequenz eingestellt werden. Da diese Werte, ebenso wie die gewünschten Frequenzgangverläufe für das Signalfilter und die Charakteristiken des Steuerungsfilters je nach gewünschter Frequenzgangbeeinflussung verschieden sind, kann für sie keine allgemeine Regel angegeben werden. Vielmehr ist in den meisten Fällen die Auswahl der Komponenten bzw. Filtercharakteristiken experimentiell vorzunehmen.

Die Schaltungsanordnung gestattet es, quasi beliebige Charakteristiken zur Frequenzgangbeeinflussung vorzunehmen. Es sind dazu lediglich die Filtercharakteristiken bzw. die Koeffizienten sowie die Impulsformerstufe jeweils angepaßt auszulegen. Trotz dieser großen Variabilität weist die Schaltungsanordnung einen einfachen Aufbau auf.

Nach einer Ausgestaltung der Erfindung ist vorgesehen, daß der Impulsformer ein Anstiegsfilter und ein Abklingfilter aufweist, bei denen es sich um Tiefpaßfilter handelt, und welche das Impulsverhalten der den Impulsformer durchlaufenden Signale in der Weise beeinflussen, daß das Anstiegsfilter die minimale Zeitkonstante ansteigender Flanken des Signals bestimmt und daß das Abklingfilter die minimale Zeitkonstante abfallender Flanken des Signals bestimmt.

Das Anstiegsfilter und das Abklingfilter bestimmen die Zeitkonstanten, welche Flanken des den Impulsformer durchlaufenden Signals minimal aufweisen können. Die Zeitkonstante des Anstiegsfilters bestimmt dabei, welche Steilheit ansteigende Flanken des Signals aufweisen können. Das Abklingfilter bestimmt die Zeitkonstante der abfallenden Flanken. Durch diese beiden Filter wird das dynamische Verhalten der Schaltungsanordnung beeinflußt. So ist es in vielen Fällen nach einem Frequenz- und/oder Amplitudensprung des Eingangssignals der Schaltungsanordnung nicht wünschenswert, sofort die Frequenzcharakteristik des Signalfilters an die neue Amplitude und/oder Frequenz anzupassen. Vielmehr wird dieser Übergang vielfach verzögert vorgenommen. Diese Verzögerungszeit, mit der die Frequenzgangbeeinflussung auf die neue Frequenz und/oder Amplitude eingestellt wird, kann durch die Zeitkonstanten des Anstiegsfilters sowie des Abklingfilters eingestellt werden.

Nach einer weiteren Ausgestaltung der Erfindung ist vorgesehen, daß das Anstiegsfilter mit in Abhängigkeit der Amplitude des ihm zugeführten Signals veränderter Zeitkonstante arbeitet und daß das Filter zu höheren Amplituden des Signals hin mit kleineren Zeitkonstanten arbeitet.

Bei vielen Rauschunterdrückungsschaltungen, für die die digitale Schaltungsanordnung vorgesehen sein kann, sind die Zeitkonstanten für das dynamische Verhalten in Abhängigkeit der Amplitude des Eingangssignals der Schaltungsanordnung verschieden zu wählen. Für diesen Fall kann das Anstiegsfilter vorteilhaft mit variabler Zeitkonstante arbeiten, welche in Abhängigkeit der Amplituden des Signals variiert wird.

Gemäß einer weiteren Ausgestaltung ist vorgesehen, daß es sich bei dem Anstiegsfilter um ein digitales Filter erster Ordnung handelt, das die Übertragungsfunktion

$$H(e^{j\omega T}) = \frac{e_0 + e_0\ e^{-j\omega T}}{1 + f_1\ e^{-j\omega T}}$$

aufweist, mit: $T = 1/F$, $F$ = Abtastfrequenz des digitalen Audiosignals, $e_0 = k_1$ + Ausgangssignal des Filters, $f_1 = k_2$ + invertiertes Ausgangssignal des Filters.

Das Anstiegsfilter braucht im allgemeinen nur als digitales Filter erster Ordnung ausgelegt zu sein. Ein solches Filter arbeitet mit vier Filterkoeffizienten. Für die vorliegende Anwendung reichen jedoch zwei Koeffizienten aus, so daß nur noch die Koeffizienten $e_0$ und $f_1$ einzustellen sind. Um das Anstiegsfilter bezüglich seiner Charakteristik an die Amplitude des Eingangssignals anzupassen, ist vorgesehen, daß der Koeffizient $e_0$ sich aus einem konstanten Wert $k_1$ und dem Ausgangssignal des Filters zusammensetzt. Für den Koeffizienten $f_1$ ist vorgesehen, daß er sich aus einem konstanten Wert $k_2$ und dem invertierten Ausgangssignal des Filters zusammensetzt. Auf diese Weise wird erreicht, daß die beiden Filterkoeffizienten in $e_0$ und $f_1$ in Abhängigkeit der Signalamplitude variiert werden.

Nach weiteren Ausgestaltungen der Erfindung ist vorgesehen, daß es sich bei dem Steuerungsfilter um ein Hochpaßfilter handelt und daß das Steuerungsfilter als digitales Filter erster Ordnung ausgelegt ist, daß die Übertragungsfunktion

$$H(e^{j\omega T}) = \frac{c_0 + c_1 \, e^{-j\omega T}}{1 + d_1 \, e^{-j\omega T}}$$

aufweist, worin gilt: T = 1/F, F = Abtastfrequenz des digitalen Audiosignals, Filterkoeffizienten $c_0$, $c_1$, $d_1$ weisen konstante Werte auf.

Die Dimensionierung der Filterkoeffizienten $c_0$, $c_1$ und $d_1$ bestimmt sowohl das statische wie auch das dynamische Verhalten der Schaltungsanordnung.

Auch das Signalfilter kann, wie nach einer weiteren Ausgestaltung der Erfindung vorgesehen ist, als digitales Filter erster Ordnung ausgelegt werden, das folgende Übertragungsfunktion aufweist:

$$H(e^{j\omega T}) = \frac{a_0 - a_0 \, e^{-j\omega T}}{1 + b_1 \, e^{-j\omega T}}$$

in der gilt: T = 1/F, F = Abtastfrequenz des digitalen Audiosignals und daß die Koeffizienten $a_0$ und $b_1$ des Filters variabel sind und in Abhängigkeit des Ausgangssignals des Steuerungszweiges gewählt werden.

Hier genügen zwei Filterkoeffizienten $a_0$ und $b_1$, welche jedoch variabel sind. Diese Filterkoeffizienten werden in Abhängigkeit des Ausgangssignals des Steuerungszweiges ausgewählt. Die Wahl dieser Koeffizienten ist so vorzunehmen, daß mittels des Ausgangssignals des Signalfilters, das mit dem Eingangssignal der Schaltungsanordnung addiert wird, die gewünschten Frequenzgangverläufe erzielt werden können. Da die theoretische Bestimmung auch dieser Werte extrem aufwendig ist, werden sie am besten experimentiell ermittelt.

Nach einer Ausgestaltung der Erfindung ist vorgesehen, daß die Koeffizientenermittlungsanordnung einen Festwertspeicher aufweist, der vom Ausgangssignal des Logarithmierers angesteuert wird, und daß in dem Festwertspeicher jeweils 100 Werte der für das Signalfilter benötigen Filterkoeffizienten abgespeichert sind.

Die benötigten Filterkoeffizienten können auf einfache Weise in einem Festwertspeicher abgespeichert sein, in welchem sie in Abhängigkeit des Ausgangssignals des Logarithmierers abgerufen werden. Für die beiden Filterkoeffizienten genügt es im allgemeinen, je 100 Werte abzuspeichern. Auf diese Weise können also wenigstens 100 verschiedene Frequenzgangverläufe erzielt werden. Es hat sich gezeigt, daß diese Stufigkeit in den verschiedenen Frequenzgangverläufen im allgemeinen nicht mehr hörbar ist und für die meisten Rauschunterdrückungssysteme ausreichend ist.

Gemäß einer weiteren Ausgestaltung der Erfindung ist vorgesehen, daß die Koeffizientenermittlungsanordnung die für das Signalfilter benötigten Filterkoeffizienten in Abhängigkeit des Ausgangssignals des Logarithmierers gemäß vorgegebenen mathematischen Gleichungen berechnet.

Anstelle eines Festwertspeichers kann in der Koeffizientenermittlungsanordnung vorteilhaft eine Berechnung der Filterkoeffizienten vorgenommen werden. Es sind dafür mathematische Gleichungen vorzugeben, gemäß denen die Filterkoeffizienten berechnet werden. Diese Lösung bietet gegenüber der Lösung mit dem Festwertspeicher insbesondere dann Vorteile, wenn die Gesamtschaltungsanordnung ein gutes Klirrverhalten aufweisen soll und infolgedessen sehr viele Filterkoeffizienten benötigt werden.

Die rechnerische Ermittlung dieser Filterkoeffizienten kann für das oben beschriebene Signalfilter mit nur zwei Filterkoeffizienten vorteilhaft durch folgende Gleichungen berechnet werden:

$$a_0 = L_1 \times f(z) + L_2$$
$$b_1 = L_3 \times f(z) + L_4 \, ,$$

in denen f(z) das Ausgangssignal des Logarithmierers (12) ist und in denen $L_1$ bis $L_4$ vorgegebene, konstante Werte aufweisen.

Die erfindungsgemäße Schaltungsanordnung, deren Steuerung vorteilhaft mittels eines digitalen Signalprozessors vorgenommen werden kann, kann insbesondere für die Frequenzgangbeeinflussung entsprechend den Charakteristiken analoger Rauschunterdrückungsschaltungen eingesetzt werden. Zu diesen gehört beispielsweise das Dolby-B-System. Beispielsweise für die Dekodierung entsprechend den Charakteristiken von analogen Dolby-B-Schaltkreisen genügt es, daß Signalfilter als Tiefpaßfilter erster Ordnung auszulegen.

In einigen Rauschunterdrückungssystemen, beispielsweise auch denen gemäß dem Dolby-B-System, ist auf der Enkoderseite vorgesehen, bei Überschreiten von bestimmten Amplitudenwerten eine Begrenzung des Signals vorzunehmen. Diese Begrenzung muß wiedergabeseitig, also dekoderseitig, wieder rückgängig gemacht werden. Dazu ist nach einer weiteren Ausgestaltung der Erfindung vorgesehen, daß das Ausgangssignal des Signalfilters vor Addition mit dem Eingangssignal der Schaltungsanordnung einem Multiplizierer zugeführt wird, in welchem das Signal bei Unterschreiten eines vorgegebenen Amplitudenwertes mit dem Wert 1 und bei Überschreiten des vorgegebenen Amplitudenwertes mit einem Wert etwas größer als 1 multipliziert wird und daß der vorgegebene Wert so gewählt ist, daß sein Überschreiten ein Ansprechen einer Begrenzungsfunktion beim Kodiervorgang des digitalen Signals angibt.

Wie nach weiterer Ausgestaltungen der Erfindung vorgesehen ist, kann die Schaltungsanordnung auch für komplexere Rauschunterdrückungssysteme eingesetzt werden, beispielsweise zur Erzeugung von Frequenzgangcharakteristiken entsprechend analogen Dolby-C-Schaltkreisen. Dabei gibt es zum einen die Möglichkeit, zwei Schaltungsanordnungen gemäß der Erfindung hintereinanderzuschalten, welche unabhängig voneinander arbeiten. Zum anderen besteht die Möglichkeit, daß Signalfilter und das Steuerungsfilter als digitale Filter zweiter Ordnung auszulegen; es genügt dann eine erfindungsgemäße Schaltungsanordnung.

Im folgenden wird anhand der Zeichnung ein Ausführungsbeispiel der Erfindung näher erläutert. Es zeigen:

Fig. 1 ein Blockschaltbild einer als Dolby-B-Dekoder arbeitenden digitalen Schaltungsanordnung zur frequenz- und amplitudenabhängigen Frequenzgangbeeinflussung eines digitalen Audiosignals,

Fig. 2 eine detailliertere Darstellung des Signalfilters der Anordnung gemäß Fig. 1,

Fig. 3 eine detaillierte Darstellung des Signalfilters der Anordnung gemäß Fig. 1 und

Fig. 4 eine detaillierte Darstellung der Impulsformerstufe der Anordnung gemäß Fig. 1.

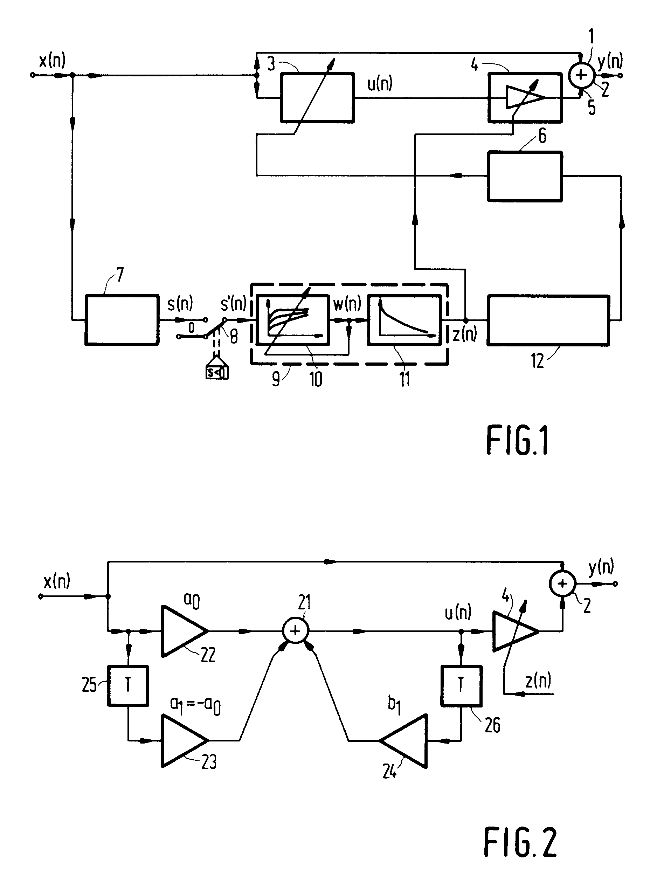

Eine in Fig. 1 in Form eines Blockschaltbildes dargestellte digitale Schaltungsanordnung ist als Dekoder vorgesehen, welcher Frequenzgangcharakteristiken gemäß dem Dolby-B-System erzeugt. Dazu ist der Schaltungsanordnung ein digitales Audiosignal x(n) zugeführt, bei dem es sich beispielsweise um ein von dem analogen in den digitalen Bereich umgesetztes Audiosignal handeln kann.

Dieses Signal ist innerhalb der Schaltungsanordnung einem ersten Eingang 1 eines Addierers 2 sowie einem Signalfilter 3 zugeführt. Das Ausgangssignal des Signalfilters 3 gelangt auf einen Multiplizierer 4, dessen Ausgangssignal einem zweiten Eingang 5 des Addierers 2 zugeführt ist. Das Ausgangssignal des Addierers 2, das in der Fig. mit y(n) bezeichnet ist, stellt das dekodierte Ausgangssignal der Schaltungsanordnung dar.

Das digitale Audiosignal durchläuft also zum einen einen Hauptzweig, in dem es nicht beeinflußt wird und zum anderen einen Nebenzweig, in dem es das Signalfilter 3 und den Multiplizierer 4 durchläuft. Die Signale des Haupt- und des Nebenzweiges werden addiert und bilden das Ausgangssignal y(n) der Schaltungsanordnung.

Das Signalfilter 3 dient dazu, den Frequenzgang des Signals x(n) in gewünschter Weise in Abhängigkeit von dessen Frequenz und Amplitude zu beeinflussen. Es handelt sich um ein Tiefpaßfilter erster Ordnung, das zur gewünschten Frequenzgangbeeinflussung variable Filterkoeffizienten aufweist. Die Filterkoeffizienten für das Signalfilter 3 werden diesem von einer Koeffizientenermittlungsanordnung 6 zugeführt. Diese Koeffizientenermittlungsanordnung 6 ihrerseits wird vom Ausgangssignal eines im folgenden näher beschriebenen Steuerungszweiges angesteuert.

In dem Steuerungszweig, dem eingangsseitig das Eingangssignal der Schaltungsanordnung x(n) zugeführt wird, ist ein Steuerungsfilter 7 vorgesehen, bei dem es sich um ein digitales Filter erster Ordnung handelt, welches mit konstanten Filterkoeffizienten arbeitet. Die Charakteristik dieses Filters beeinflußt sowohl das statische Verhalten wie auch das dynamische Verhalten der Schaltungsanordnung. Soll, wie in dem in der Zeichnung dargestellten Beispiel, die Schaltungsanordnung als Dekoder für ein Dolby-B-System arbeiten, so ist dieses Filter als Hochpaßfilter auszulegen.

Das Ausgangssignal des Steuerungsfilters 7, in der Fig. mit s(n) bezeichnet, gelangt auf einen in der Fig. als Schalter 8 angedeuteten Gleichrichter, welcher Signalwerte s(n) < 0 unterdrückt. Das so gleichgerichtete und in der Fig. mit s'(n) bezeichnete Signal gelangt nachfolgend auf eine Impulsformerstufe 9. In der Impulsformerstufe 9 werden die Anstiegs- und Abfallzeiten des ihm zugeführten Signals s'(n) mit Zeitkonstanten beaufschlagt. Dazu ist innerhalb der Impulsformerstufe 9 ein Anstiegsfilter 10 vorgesehen, welches die minimalen Zeitkonstante ansteigender Flanken des ihm zugeführten Signals bestimmt. Dieses Anstiegsfilter 10 ist als variables Filter ausgelegt, dessen Filterkoeffizienten in Abhängigkeit seines Ausgangssignals w(n) gewählt werden. Dem Anstiegsfilter 10 ist innerhalb der Impulsformerstufe 9 ein Abklingfilter 11 nachgeschaltet, welches mit einer festen Zeitkonstante und somit auch mit fest vorgegebenen Filterkoeffizienten arbeitet. Dieses Filter bestimmt die minimalen Zeitkonstante abfallender Flanken des ihm zugeführten Signals w(n). Das Ausgangssignal des Abklingfilters 11, das in der Fig. mit z(n) bezeichnet ist, stellt das Ausgangssignal der Impulsformerstufe 9 dar und gelangt nachfolgend auf einen Logarithmierer 12, in welchem dieses Signal logarithmiert wird. Es handelt sich vorzugsweise um einen modifizierten Logarithmierer, der aus dem Ausgangssignal Z der Impulsformerstufe 9 sein Ausgangssignal f(z) nach der Gleichung $f(z) = A + Bz^{1/3} \cdot Cz^{2/3} + Dz$ berechnet, in der A, B, C und D konstante Werte aufweisen. Das Ausgangssignal des Logarithmierers 12 stellt eine Art Zeiger dar, der der Koeffizientenermittlungsanordnung 6 zugeführt wird und welcher innerhalb dieses Festwertspeichers die gewünschte Auswahl der Filterkoeffizienten für das Signalfilter 3 auslöst.

Das Verhalten der in Fig. 1 dargestellten Schaltungsanordnung kann frei auf die gewünschte Art einer Frequenzgangbeeinflussung eingestellt werden. Es ist klar, daß das Signalfilter 3 bzw. die ihm zugeführten variablen Filterkoeffizienten so ausgelegt sein müssen, daß nach Addition in dem Addierer 2 mit dem Eingangssignal der Schaltungsanordnung die gewünschten Charakteristiken zur Frequenzgangbeeinflussung vorgenommen werden können. Die Auswahl der Filterkoeffizienten in der Koeffizientenermittlungsanordnung 6 wird mittels des Steuerungszweiges vorgenommen. In diesem Steuerungszweig beeinflußt das Steuerungsfilter 7 sowohl das statische wie auch das dynamische Verhalten der Schaltungsanordnung. Bezüglich des statischen Verhaltens ist die Impulsformerstufe 9 quasi ohne Wirkung. Liegt also ein Eingangssignal x(n) konstanter Frequenz und Amplitude an, so wird über das Signalfilter und die dann unwirksame Impulsformerstufe 9 nach Logarithmierung deren Ausgangssignals in der Koeffizientenermittlungsanordnung 6 ein bestimmtes Koeffizientenpaar ausgewählt und das Signalfilter 3 auf die gewünschte Frequenzgangbeeinflussung eingestellt. Ändert nun das eingangsseitige Signal seine Frequenz und/oder Amplitude, so ist das Signalfilter 3 auf einen neuen Frequenzgang einzustellen. Der Übergang auf diesen neuen einzustellenden Frequenzgang geschieht jedoch nicht übergangslos, sondern mit einem bestimmten dynamischen Verhalten. Dieses dynamische Verhalten analoger Rauschunterdrückungssysteme ist übrigens in deren Spezifikationen nicht explizit festgelegt. Das dynamische Verhalten ergibt sich vielmehr dadurch, daß bestimmte analoge Schaltungsaufbauten vorgesehen sind, welche in der Praxis ein bestimmtes dynamisches Verhalten aufweisen. Für die Auslegung der erfindungsgemäßen Schaltungsanordnung kann daher nur das dynamische Verhalten dieser analogen Anordnungen gemessen und mittels der digitalen Schaltungsanordnung simuliert werden. Die Auslegung der digitalen Schaltungsanordnung kann daher nur auf experientiellem Wege erfolgen. Dieses dynamische Verhalten wird durch das Anstiegsfilter, das Abklingfilter bzw. die durch diese bestimmten minimalen Zeitkonstanten für die Auswahl neuer Koeffizienten sowie auch durch den Frequenzgang des Steuerungsfilters bestimmt.

In der Anorndung gemaß Fig. 1 wird also ein sich änderndes Signal x(n) ein neues Ausgangssignal s(n) des Signalfilters 7 erzeugen. Damit erfolgt jedoch noch nicht unmittelbar eine entsprechende Änderung der Filterkoeffizienten, da in der Impulsformerstufe 9 das sich ändernde Signal s(n) bzw. s'(n) mit Zeitkonstanten beaufschlagt wird, welche dazu führen, daß das in dem Logarithmierer 12 anschließend logarithmierte Signal erst langsam den neuen Sollwert annimmt. Somit wird also auch in der Koeffizientenermittlungsanordnung 6 nach Auswahl verschiedener Zwischenwerte für die Filterkoeffizienten erst nach einer Übergangzeit der neue statische Wert für das neue Eingangssignal x-(n) eingestellt. Die Übergangszeiten zu größeren bzw. niedrigeren Amplituden oder Frequenzen des Eingangssignals wird durch die Zeitkonstanten des Anstiegsfilters 10 sowie des Abklingfilters 11 in der Impulsformerstufe 9 bestimmt.

Für viele Rauschunterdrückungssysteme ist eine amplitudenabhängige Begrenzung des Signals vorgesehen. So ist beispielsweise für Dolby-B-Systeme vorgesehen, enkoderseitig, also aufnahmeseitig, das Signal bei bestimmten Amplituden bzw. Frequenzen zu begrenzen. Um diese Begrenzung wiedergabeseitig im Dekoder rückgängig zu machen, ist in der Anordnung gemäß Fig. 1 der Multiplizierer 4 vorgesehen, welchem das Ausgangssignal der Impulsformerstufe 9 zugeführt wird. Dieser Multiplizierer 4 multipliziert das ihn durchlaufende Signal normalerweise mit dem Faktor 1, läßt es also unbeeinflußt. Erst wenn der Schaltungsanordnung Signale zugeführt werden, welche eine Amplitude und/oder Frequenz aufweisen, welche darauf schließen läßt, daß das Signal enkoderseitig begrenzt wurde, wird das den Multiplizierer 4 durchlaufende Signal mit einem Faktor > 1 beeinflußt, so daß die enkoderseitig vorgenommene Begrenzung dadurch rückgängig gemacht wird. Es ist klar, daß der Multiplizierer 4 für die Grundfunktion der Schaltungsanordnung nicht erforderlich ist und somit gegebenenfalls entfallen kann.

In Fig. 2 sind der Haupt- und Nebenzweig der Anordnung gemäß Fig. 1 näher dargestellt. Insbesondere ist das Signalfilter 3 in seinem Aufbau detailliert dargestellt. Das Signalfilter 3, bei dem es sich um ein digitales Tiefpaßfilter erster Ordnung handelt, weist einen Addierer 21 auf, welchem das in einem Multiplizierer 22 mit einem Filterkoeffizienten $a_0$ beaufschlagte Eingangssignal der Schaltungsanordnung, das in eiem Verzögerungsglied 25 um eine Taktperiode verzögerte, in einem Multiplizierer 23 mit einem Filterkoeffizienten $a_1 = -a_0$ beaufschlagte Eingangssignal der Schaltungsanordnung sowie das um eine Taktperiode verzögerte und in einem Multiplizierer 24 mit einem Filterkoeffizienten $b_1$ beaufschlagte Ausgangssignal u(n) des Addierers 21 zugeführt wird. Dieses Signalfilter weist die Übertragungsfunktion

$$H(e^{j\omega T}) = \frac{a_0 - a_0\, e^{-j\omega T}}{1 + b_1\, e^{-j\omega T}}$$

auf. Für die Erzeugung von Dekoder-Frequenzgangcharakteristiken des Dolby-B-Systems können die Filterkoeffizienten $a_0$ und $a_1$ für die Multiplizie-

rer 22 und 23 bis auf das Vorzeichen gleich gewählt werden. Somit müssen dem Filter nur noch die Filterkoeffizienten $a_0$ und $b_1$ zugeführt werden. Diese Filterkoeffizienten werden in Abhängigkeit des Ausgangssignals des Logarithmierers der Anordnung gemäß Fig. 1 in der Koeffizientenermittlungsanordnung 6 ausgewählt.

Das Ausgangssignal $u(n)$ des Addierers 21 und damit des Signalfilters 3 gelangt nach Durchlaufen des Multiplizierers 4 und anschließender Addition mit dem Eingangssignal $x(n)$ der Schaltungsanordnung im Addierer 2 auf den Ausgang der Schaltungsanordnung und stellt das Ausgangssignal, also das dekodierte digitale Audiosignal $y(n)$ der Schaltungsanordnung dar.

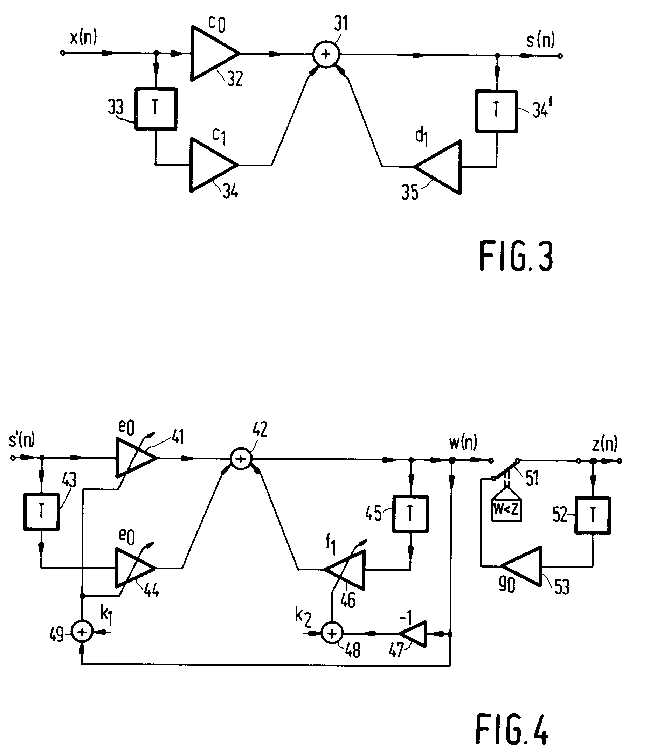

In Fig. 3 ist das Signalfilter 7 der Anordnung gemäß Fig. 1 detailliert dargestellt. Dem Filter wird eingangsseitig das digitale Audiosignal $x(n)$ zugeführt. Bei dem in der Fig. 3 dargestellten Signalfilter handelt es sich um ein digitales Filter erster Ordnung, das als Hochpaßfilter ausgelegt ist. Eine solche Hochpaßcharakteristik ist für die Dekodierung gemäß den Frequenzgangcharakteristiken des Dolby-B-Systems erforderlich.

In dem in Fig. 3 dargestellten Signalfilter ist ein Addierer 31 vorgesehen, welchem das Eingangssignal $x(n)$ nach Multiplikation mit einem Filterkoeffizienten $x_0$ in einem Multiplizierer 32 zugeführt wird. Ferner wird dieses Eingangssignal $x(n)$ in einem Verzögerungsglied 33 um eine Abtasttaktperiode verzögert und anschließend in einem Multiplizierer 34 mit einem Filterkoeffizienten $c_1$ beaufschlagt. Das Ausgangssignal des Multiplizierers 34 gelangt auf einen weiteren Eingang des Addierers 31. Das Ausgangssignal des Addierers 31 wird über ein Verzögerungsglied 34, in welchem dieses Signal um eine Abtasttaktperiode verzögert wird und einen nachgeschalteten Multiplizierer 35, in welchem das Ausgangssignal des Verzögerungsgliedes 34 mit einem Filterkoeffizienten $d_1$ beaufschlagt wird, auf einen Eingang des Addierers 31 zurückgeführt. Das Ausgangssignal des Addierers 31 bildet gleichzeitig das Ausgangssignal des Signalfilters, das in der Fig. mit $s(n)$ bezeichnet ist. Dieses Filter weist die Übertragungsfunktion

$$H(e^{j\omega T}) = \frac{c_0 + c_1\ e^{-j\omega T}}{1 + d_1\ e^{-j\omega T}}$$

auf. Die Filterkoeffizienten $c_0$, $c_1$ und $d_1$ weisen konstante Werte auf und sind so ausgelegt, daß die Gesamtschaltungsanordnung gemäß Fig. 1 das gewünschte statische und dynamische Verhalten aufweist.

In Fig. 4 ist der Impulsformer 9 gemäß Fig. 1 näher dargestellt. Insbesondere sind das Anstiegsfilter 10 und das Abklingfilter 11 in der Fig. 4 detailliert dargestellt. Dem in Fig. 4 dargestellten Impulsformer wird eingangsseitig das gleichgerichtete Ausgangssignal $s'(n)$ des Steuerungsfilters zugeführt. Dieses Signal gelangt über einen Multiplizierer 41, in welchem es mit einem Filterkoeffizienten $e_0$ beaufschlagt wird, auf einen Eingang eines Addierers 42. Einem weiteren Eingang des Addierers 42 wird das in einem Verzögerungsglied 43 um eine Abtasttaktperiode verzögerte und anschließend in einen Multiplizierer 44 mit dem Filterkoeffizienten $e_0$ beaufschlagte Eingangssignal $s'(n)$ zugeführt. Das Ausgangssignal des Addierers 42 wird über ein Verzögerungsglied 45, in welchem es um eine Abtasttaktperiode verzögert wird, und einem diesem nachgeschalteten Multiplizierer 46, in welchem dieses Signal mit einem Filterkoeffizienten $f_1$ beaufschlagt wird, auf einen weiteren Eingang des Addierers 42 zurückgeführt. Das in der Fig. 4 mit $w(n)$ bezeichnete Ausgangssignal des Addierers 42 stellt auch das Ausgangssignal des Anstiegsfilters dar.

Das Anstiegsfilter ist bezüglich seiner Filterkoeffizienten $e_0$ und $f_1$ variabel ausgelegt. Diese Filterkoeffizienten $e_0$ und $f_1$ sind nämlich von der Amplitude des Ausgangssignals $w(n)$ abhängig. Dazu wird das Signal $w(n)$ einem Addierer 49 zugeführt, in welchem es mit einem festen Wert $k_1$ addiert wird. Das Ausgangssignal des Addierers 49 stellt nun den Filterkoeffizienten $e_0$ für die Multiplizierer 41 und 44 dar.

Zur Gewinnung des Filterkoeffizienten $f_1$ wird das Ausgangssignal $w(n)$ in einem Multiplizierer 47 invertiert, also mit dem Wert -1 multipliziert und anschließend in einem Addierer 48 mit einem festen Wert $k_2$ addiert. Das Ausgangssignal des Addierers 48 bildet den Filterkoeffizienten $f_1$ für den Multiplizierer 46.

Im Ergebnis wird durch diese Art der Erzeugung der Filterkoeffizienten $e_0$ und $f_1$ erreicht, daß die Filtercharakteristiken des Filters in Abhängigkeit von dessen Ausgangssignal $w(n)$ variiert werden. Da das Anstiegsfilter die minimale Zeitkonstante für ansteigende Flanken des ihm zugeführten Signals $s'(n)$ bestimmt, kann durch die Wahl der Filterkoeffizienten in $e_0$ und $f_1$ das dynamische Verhalten der Gesamtschaltungsanordnung gemäß Fig. 1 bestimmt werden. Da dieses Verhalten, beispielsweise für Dolby-B-Schaltkreise, amplitudenabhängig sein soll, werden die Filterkoeffizienten $e_0$ und $f_1$ in Abhängigkeit des Filterausgangssignals $w(n)$ gewählt. Die Größe der Filterkoeffizienten $e_0$ und $f_1$ in dem Anstiegsfilter bestimmt das dynamische Verhalten der Schaltungsanordnung bei einem Übergang von niedrigeren zu größeren Amplituden des digitalen Audiosignals bzw. bei einem Übergang von niedrigeren zu höheren Frequenzen des Audiosignals.

In der Fig. 4 ist ferner das Abklingfilter 11 der Anordnung gemäß Fig. 1 näher dargestellt. Bei diesem Filter handelt es sich um ein Filter erster Ordnung, welches mit einem konstanten Filterkoeffizienten $g_0$ arbeitet.

In der Darstellung gemäß Fig. 1 ist für dieses Filter ein Schalter 51 angedeutet, welcher entweder das Ausgangssignal w(n) des Anstiegsfilters auf den Abklingfilterausgang schaltet, oder welche das Ausgangssignal des Abklingfilters, das in der Fig. mit z(n) bezeichnet ist, über ein Verzögerungsglied 52, in welchem das Signal um eine Abtasttaktperiode verzögert wird, und einen diesem nachgeschalteten Multiplizierer 53, in welchem das ihn durchlaufende Signal mit dem Filterkoeffizienten $g_0$ beaufschlagt wird, auf den Filterausgang führt. Der Schalter 51 wird in Abhängigkeit des Wertes des Signals w(n) im Vergleich zu dem Wert des Signals z(n) gewählt. Während derjenigen Zeiten, in denen das Signal w(n) kleinere Werte aufweist als das Signal z(n), wird das Ausgangssignal z(n) über das Verzögerungsglied 52 und dem Multiplizierer 53 auf den Ausgang rückgeführt. Während der übrigen Zeiten gelangt das Signal w(n) direkt als Ausgangssignal z(n) auf den Ausgang des Abklingfilters 11.

Das Ausgangssignal z(n) des Abklingfilters stellt gleichzeitig das Ausgangssignal der Impulsformerstufe 9 gemäß Fig. 1 dar.

Die Wahl des Filterkoeffizienten $g_0$ in dem Abklingfilter bestimmt das Ausschwingverhalten der Schaltungsanordnung gemäß Fig. 1, also das Verhalten bei einem Übergang von größeren zu niedrigeren des Amplituden des digitalen Audiosignals bzw. bei einem Übergang von höheren zu niedrigeren Frequenzen des digitalen Audiosignals.

Die digitalen Filter erster Ordnung wurden als Filter der Direkt-Form I beschrieben. Da jedoch durchweg rekursive Filter verwendet werden, können diese Filter vorteilhaft als sogenannte Wellendigitalfilter verwirklicht werden, bei denen keine Stabilitätsprobleme auftreten. Dies gilt insbesondere für das Stabilitätsverhalten unter nichtlinearen Bedingungen.

**Patentansprüche**

1. Digitale Schaltungsanordnung zur frequenz- und/oder amplitudenabhängigen Frequenzgangbeeinflussung eines digitalen Audiosignals,
dadurch gekennzeichnet, daß das Eingangssignal der Schaltungsanordnung einem Signalfilter (3) mit variablen Filterkoeffizienten zugeführt wird, dessen Ausgangssignal nach Addition mit dem Eingangssignal der Schaltungsanordnung das frequenzgangbeeinflußte Ausgangssignal der Schaltungsanordnung darstellt, und daß die Koeffizientenauswahl für das Signalfilter in Abhängigkeit des Ausgangssignals eines Steuerungszweiges vorgenommen wird, welchem das Eingangssignal der Schaltungsanordnung zugeführt wird und welcher ein Steuerungsfilter (7), einen Gleichrichter (8), eine Impulsformerstufe (9), einen Logarithmierer (12) und eine Koeffizientenermittlungsanordnung (6) aufweist, welche die Filterkoeffizienten für das Signalfilter (3) liefert.

2. Schaltungsanordnung nach Anspruch 1,
dadurch gekennzeichnet, daß der Impulsformer (9) ein Anstiegsfilter (10) und ein Abklingfilter (11) aufweist, bei denen es sich um Tiefpaßfilter handelt, und welche das Impulsverhalten der den Impulsformer (9) durchlaufenden Signale in der Weise beeinflussen, daß das Anstiegsfilter (10) die minimale Zeitkonstante ansteigender Flanken des Signals bestimmt und daß das Abklingfilter (11) die minimale Zeitkonstante abfallender Flanken des Signals bestimmt.

3. Schaltungsanordnung nach Anspruch 2,
dadurch gekennzeichnet, daß das Anstiegsfilter (10) mit in Abhängigkeit der Amplitude des ihm zugeführten Signals veränderter Zeitkonstante arbeitet und daß das Filter (10) zu höheren Amplituden des Signals hin mit kleineren Zeitkonstanten arbeitet.

4. Schaltungsanordnung nach Anspruch 2 oder 3,
dadurch gekennzeichnet, daß es sich bei dem Anstiegsfilter (10) um ein digitales Filter erster Ordnung handelt, das die Übertragungsfunktion

$$H(e^{j\omega T}) = \frac{e_0 + e_0\, e^{-j\omega T}}{1 + f_1\, e^{-j\omega T}}$$

aufweist, mit: T = 1/F, F = Abtastfrequenz des digitalen Audiosignals, $e_0 = k_1 +$ Ausgangssignal des Filters (10), $f_1 = k_2 +$ invertiertes Ausgangssignal des Filters.

5. Schaltungsanordnung nach einem der Ansprüche 1 bis 4,
dadurch gekennzeichnet, daß es sich bei dem Steuerungsfilter (7) um ein Hochpaßfilter handelt.

6. Schaltungsanordnung nach einem der Ansprüche 1 bis 5,

dadurch gekennzeichnet, daß es sich bei dem Steuerungsfilter (7) um ein digitales Filter erster Ordnung handelt, das die Übertragungsfunktion

$$H(e^{j\omega T}) = \frac{c_0 + c_1 \, e^{-j\omega T}}{1 + d_1 \, e^{-j\omega T}}$$

aufweist, worin gilt: $T = 1/F$, $F$ = Abtastfrequenz des digitalen Audiosignals, Filterkoeffizienten $c_0$, $c_1$, $d_1$ weisen konstante Werte auf.

7. Schaltungsanordnung nach einem der Ansprüche 1 bis 6,
dadurch gekennzeichnet, daß es sich bei dem Signalfilter (3) um ein digitales Filter erster Ordnung handelt, das folgende Übertragungsfunktion aufweist:

$$H(e^{j\omega T}) = \frac{a_0 - a_0 \, e^{-j\omega T}}{1 + b_1 \, e^{-j\omega T}}$$

in der gilt: $T = 1/F$, $F$ = Abtastfrequenz des digitalen Audiosignals und daS die Koeffizienten $a_0$ und $b_1$ des Filters (3) variabel sind und in Abhängigkeit des Ausgangssignals des Logarithmierers (12) gewählt werden.

8. Schaltungsanordnung nach einem der Ansprüche 1 bis 7,
dadurch gekennzeichnet, daß die Koeffizientenermittlungsanordnung (6) einen Festwertspeicher aufweist, der vom Ausgangssignal des Logarithmierers (12) angesteuert wird, und daß in dem Festwertspeicher jeweils 100 Werte der für das Signalfilter (3) benötigen Filterkoeffizienten abgespeichert sind.

9. Schaltungsanordnung nach einem der Ansprüche 1 bis 7,
dadurch gekennzeichnet, daß die Koeffizientenermittlungsanordnung (6) die für das Signalfilter (8) benötigten Filterkoeffizienten in Abhängigkeit des Ausgangssignals des Logarithmierers (12) gemäß vorgegebenen mathematischen Gleichungen berechnet.

10. Schaltungsanordnung nach Anspruch 7 und Anspruch 9,
dadurch gekennzeichnet, daß die Filterkoeffizienten $a_0$ und $b_1$ gemäß folgenden Gleichungen berechnet werden:

$a_0 = L_1 \times f(z) + L_2$
$b_1 = L_3 \times f(z) + L_4$ ,

in denen $f(z)$ das Ausgangssignal des Logarithmierers (12) ist und in denen $L_1$ bis $L_4$ vorgegebene, konstante Werte aufweisen.

11. Schaltungsanordnung nach einem der Ansprüche 1 bis 10,
dadurch gekennzeichnet, daß der Logarithmierer eine modifizierte Logarithmierung vornimmt und aus seinem Eingangssignal z ein Ausgangssignal $f(z)$ nach der Gleichung

$f(z) = A + Bz^{1/3} + Cz^{2/3} + Dz$

berechnet, in der A, B, C und D konstante Werte aufweisen.

12. Schaltungsanordnung nach einem der Ansprüche 1 bis 11,
dadurch gekennzeichnet, daß die Steuerung der Schaltungsanordnung mittels eines digitalen Signalprozessors vorgenommen wird.

13. Schaltungsanordnung nach einem der Ansprüche 1 bis 12,
dadurch gekennzeichnet, daß die Schaltungsanordnung zur Frequenzgangbeeinflussung entsprechend den Charakteristiken eines analogen Dolby-B-Schaltkreises eingesetzt wird.

14. Schaltungsanordnung nach Anspruch 13,
dadurch gekennzeichnet, daß die Schaltungsanordnung für die Dekodierung entsprechend den Charakteristiken von analogen Dolby-B-Schaltkreisen eingesetzt wird und daß das Signalfilter (3) als Tiefpaßfilter erster Ordnung ausgelegt ist.

15. Schaltungsanordnung nach einem der Ansprüche 1 bis 14,
dadurch gekennzeichnet, daß das Ausgangssignal des Signalfilters (3) vor Addition mit dem Eingangssignal der Schaltungsanorndung einem Multiplizierer (4) zugeführt wird, in welchem das Signal bei Unterschreiten eines vorgegebenen Amplitudenwertes mit dem Wert 1 und bei Überschreiten des vorgegebenen Amplitudenwertes mit einem Wert etwas größer als 1 multipliziert wird und daß der vorgegebene Wert so gewählt ist, daß sein Überschreiten ein Ansprechen einer Begrenzungsfunktion beim Kodiervorgang des digitalen Signals angibt.

**16.** Schaltungsanordnung nach einem der Ansprüche 1 bis 15,
dadurch gekennzeichnet, daß die digitale Schaltungsanordnung zur Frequenzgangbeeinflussung entsprechend den Charakteristiken der analogen Dolby-C-Schaltkreise eingesetzt wird und daß zwei unabhängig voneinander arbeitende Schaltungsanordnungen hintereinandergeschaltet sind.

**17.** Schaltungsanordnung nach einem der Ansprüche 1 bis 16,
dadurch gekennzeichnet, daß die Schaltungsanordnung zur Frequenzgangbeeinflussung entsprechend den Charakteristiken von analogen Dolby-C-Schaltkreisen eingesetzt wird und daß das Signalfilter (3) und das Steuerungsfilter (7) als digitale Filter zweiter Ordnung ausgelegt sind.

x(n)

1

3

u(n)

4

y(n)

2

5

6

7

s(n)

s'(n)

0

8

w(n)

z(n)

s<0

9

10

11

12

## FIG.1

x(n)

y(n)

2

$a_0$

21

u(n)

4

22

25

T

$a_1 = -a_0$

$b_1$

T

z(n)

23

24

26

## FIG.2

11

FIG.3

FIG.4